**Europäisches Patentamt**

**European Patent Office**

**Office européen des brevets**

(19)

(11) Veröffentlichungsnummer: **0 012 285**
**B1**

(12) **EUROPÄISCHE PATENTSCHRIFT**

(45) Veröffentlichungstag der Patentschrift:
**31.08.83**

(51) Int. Cl.³: **G 01 R 19/165**

(21) Anmeldenummer: **79104784.8**

(22) Anmeldetag: **30.11.79**

(54) Vorrichtung zur Abgabe eines optischen Signals abhängig von einer elektrischen Betriebsgrösse eines isolierten Kabels eines Energieversorgungsnetzes.

(30) Priorität: **16.12.78 DE 2854415**

(43) Veröffentlichungstag der Anmeldung:
**25.06.80 Patentblatt 80/13**

(45) Bekanntmachung des Hinweises auf die Patenterteilung:
**31.08.83 Patentblatt 83/35**

(84) Benannte Vertragsstaaten:
**AT BE CH FR GB IT NL SE**

(56) Entgegenhaltungen:
**AT-B- 319 395**
**DE-A-2 543 828**
**DE-A-2 656 275**
**DE-A-2 712 064**
**FR-A-2 102 531**
**FR-A-2 129 893**
**GB-A-1 528 984**
**US-A-3 840 808**

(73) Patentinhaber: **Karl Pfisterer Elektrotechnische Spezialartikel GmbH & Co. KG, Augsburger Strasse 375, D-7000 Stuttgart 60 (DE)**

(72) Erfinder: **Kries, Werner, Zügernbergstrasse 28, D-7056 Weinstadt-Grossheppach (DE)**
Erfinder: **Schuster, Martin, Heidestrasse 51, D-7300 Esslingen (DE)**

(74) Vertreter: **Bartels, Hans et al, Patentanwälte Bartels, Held, Wolff Lange Strasse 51, D-7000 Stuttgart 1 (DE)**

Vorrichtung zur Abgabe eines optischen Signals abhängig von einer elektrischen Betriebsgrösse
eines isolierten Kabels eines Energieversorgungsnetzes

Die Erfindung betrifft eine Vorrichtung zur Abgabe eines optischen Signals abhängig von einer elektrischen Betriebsgrösse eines isolierten Kabels eines Energieversorgungsnetzes, mit einer kapazitiv an den Leiter des Kabels angekoppelten Elektrode in einer am Kabelende anzubringenden Garnitur und einer Anzeigevorrichtung.

Um in gekapselten Schalt- oder Verteileranlagen nicht Prüfbuchsen vorsehen zu müssen, ist es bekannt, Kabelstecker für Mittelspannungs- und Hochspannungsenergierversorgungsleitungen mit einer Prüfelektrode zu versehen, die mit einer innerhalb des Kabelsteckers kapazitiv an den Leiter des Kabels angekoppelten Elektrode in Verbindung steht und entweder von aussen her zur Berührung mit einem Spannungsprüfer zugänglich ist oder als Anschluss für eine andererseits geerdete Glimmlampe dient. Nachteilig ist bei den Ausführungsformen mit einer Glimmlampe vor allem, dass die Leuchtkraft dieser Lampe wegen der geringen Spannung und Stromstärke, welche die Prüfelektrode zu liefern vermag, zumindest unter ungünstigen Bedingungen, also beispielsweise bei Helligkeit oder relativ grossem Abstand zwischen Auge und Lampe, zu gering ist, um zweifelsfrei den Betriebszustand eines Kabels ablesen zu können. Bei den anderen Ausführungsformen ist nicht nur nachteilig, dass ein Spannungsprüfer benötigt wird und daher eine Daueranzeige nicht möglich ist. Es bereitet auch häufig aus räumlichen Gründen Schwierigkeiten, mit der Prüfspitze des Spannungsprüfers an die Prüfelektrode heranzukommen. Gemeinsam ist beiden Ausführungsformen der Nachteil, dass nicht festgestellt werden kann, ob eine Spannungsanzeige auf die Betriebsspannung oder eine Ladespannung, welche das Kabel noch für eine gewisse Zeit nach dem Abtrennen vom Netz führt, zurückzuführen ist.

Bekannt ist auch eine Strommesseinrichtung (DE-A1-2 712 064), die eine in den Stromkreis, dessen Strom gemessen werden soll, legbare Stromschiene aufweist, welche von einer eisenkernlosen Wicklung als Strommessfühler sowie vom Ringkern eines Transformators umfasst wird, welcher zusammen mit nachgeschalteten Gleichrichtern die Betriebsspannung für einen dem Messfühler nachgeschalteten Verstärker sowie einen letzterem nachgeschalteten Analog-Digital-Wandler liefert. Alle Bauteile einschliesslich der mit Leuchtdioden ausgerüsteten Digitalanzeigeeinrichtung können in einen Giessharzblock eingebettet sein, aus dem nur die beiden Enden der Schiene herausschauen. Abgesehen davon, dass mit dieser Strommesseinrichtung eine Anzeige darüber, ob ein Kabel seine Betriebsspannung oder nur eine Ladespannung führt, nicht möglich ist, ist sie für isolierte Kabel und am Ende solcher Kabel anzubringende Garnituren nicht verwendbar, weil ihre Stromschiene nicht in den durch das Kabel und die Garnitur gebildeten Strompfad eingefügt werden kann, ohne die Isolation zu unterbrechen, was aus Sicherheitsgründen nicht zulässig ist. Für die Anzeige einer elektrischen Betriebsgrösse eines isolierten Kabels kommt auch ein bekannter Spannungswandler (AT-B-319 395) nicht in Frage, welcher für eine Spannungsmessung in vollisolierten, metallgekapselten Hochspannungsanlagen bestimmt ist und eine innerhalb der Metallkapselung angeordnete, den Hochspannungsleiter konzentrisch umgebende Elektrode aufweist, welche gegenüber der Metallkapselung isoliert ist. Da mit dem aus dem Hochspannungsleiter und der ihn umgebenden Elektrode gebildeten Oberspannungskondensator ein ausserhalb der Kapselung liegender Unterspannungskondensator in Reihe geschaltet ist, dessen Spannung mittels eines Verstärkers verstärkt wird, ist nur eine Messung oder Anzeige der Betriebsspannung mittels eines dem Verstärker nachgeschalteten Messinstrumentes möglich, nicht aber eine Anzeige einer Ladespannung. Ungeeignet für die Anzeige elektrischer Betriebsgrössen eines isolierten Kabels ist dieser bekannte Spannungswandler auch wegen der erforderlichen Energieversorgung des Verstärkers sowie der Notwendigkeit, ein Messinstrument benutzen zu müssen.

Der Erfindung liegt die Aufgabe zugrunde, eine Vorrichtung der eingangs genannten Art zu schaffen, welche es gestattet, ohne Schwierigkeiten die elektrischen Betriebsgrössen eines isolierten Kabels zuverlässig zu ermitteln und das Ergebnis irrtumsfrei zu erkennen, und zwar auch dann, wenn sich die Ermittlung über einen längeren Zeitraum hinweg erstreckt oder eine ständige Überwachung durchgeführt werden soll und wenn ungünstige Bedingungen, wie z.B. ungünstige Beleuchtungsverhältnisse oder ein erschwerter Zugang zu der am Kabelende vorgesehenen Garnitur wegen räumlich beengter Verhältnisse vorliegen. Diese Aufgabe löst eine Vorrichtung, wie sie im Anspruch 1 gekennzeichnet ist.

Die erfindungsgemässe Vorrichtung vermag zwischen unterschiedlichen Betriebsgrössen eines Kabels zu unterscheiden und kann daher anzeigen, ob das Kabel die Betriebsspannung führt, ob es eine Ladespannung führt oder ob es spannungslos ist, weil mittels der Eingangsschaltung und der dieser nachgeschalteten Dekodiereinrichtung die Treibereinrichtung unterschiedlich angesteuert werden kann, je nachdem, welche Betriebsgrösse vorliegt. Da das Mehrsegment-Flüssigkristall-Display die unterschiedlichen Betriebsgrössen mit unterschiedlichen Symbolen anzeigen kann, die auch bei ungünstigen Beleuchtungsverhältnissen leicht zu unterscheiden sind, sind Ablesefehler weitgehend ausgeschlossen. Durch die Vereinigung des Displays sowie der Dekodier- und Treibereinrichtung zu einer Baueinheit, die an der am Kabelende vorgesehenen Garnitur festlegbar ist, ist die Einsatzmöglichkeit der erfindungsgemässen Vorrichtung auch unter räumlich sehr beengten Verhältnissen möglich.

Dass die die Kontrolle durchführende Person während der Kontrolle kein Gerät in der Hand zu halten und an die Garnitur des Kabels heranzuführen braucht, ist aber nicht nur im Hinblick auf die Raumverhältnisse von Vorteil, sondern auch aus Sicherheitsgründen. Bei der erfindungsgemässen Vorrichtung kann eine Person stets einen so grossen Abstand von der Vorrichtung einhalten, dass sie selbst dann nicht gefährdet würde, wenn während der Kontrolle ein Durchschlag zwischen der Spannung führenden Ader des Kabels und der angekoppelten Elektrode erfolgen würde. Das vorzugsweise sieben Segmente aufweisende Mehrsegment-Flüssigkristall-Display benötigt einen so geringen Strom, dass eine zuverlässige Anzeige, und zwar auch der Ladespannung, noch mit einer relativ kleinen Ankopplungselektrode erreicht werden kann.

Die Baueinheit kann ein an ein Kontaktstück der Garnitur anlegbares Gegenkontaktstück und eine sie in Anlage am Kontaktstück haltende Verbindungseinrichtung aufweisen. Es ist dann besonders einfach, eine Garnitur mit der erfindungsgemässen Vorrichtung zu versehen und die Vorrichtung, wenn die nicht mehr benötigt wird, wieder von der Garnitur abzunehmen. Auch eine nachträgliche Ausrüstung von Garnituren, die einen Prüfkontakt für die Anlage der Prüfspitze eines Spannungsprüfers haben, mit der erfindungsgemässen Vorrichtung ist hier ohne weiters möglich.

Besonders vorteilhaft ist eine Ausbildung der Verbindungseinrichtung als Rastvorrichtung oder als Steckvorrichtung, weil derartige Vorrichtungen sich mit geringem Aufwand realisieren lassen und einen geringen Raumbedarf haben.

Durch den geringen Raumbedarf der Baueinheit ist es möglich, diese in einer Drucktaste anzuordnen. Diese kann dann vorteilhaft sein, wenn die Anzeigevorrichtung nicht ständig in Betrieb sein soll. Man kann sie dann durch einen Druck auf die Drucktaste einschalten und wieder abschalten.

In besonders einfacher Weise lässt sich eine Anzeige der unterschiedlichen Betriebsgrössen mittels unterschiedlicher Symbole auf dem Display dann verwirklichen, wenn die Eingangsschaltung zwei sich von dem mit der Elektrode verbindbaren Eingang aus teilende Zweige aufweist, die zu den beiden Eingängen eines UND-Gliedes führen und eine Gleichrichterbrücke bzw. einen Kondensator und eine mit diesem in Reihe liegende Gleichrichterbrücke enthalten, und wenn ausserdem der Ausgang des UND-Gliedes mit einem ersten Eingang der Dekodier- und Treibereinrichtung unmittelbar und mit einem zweiten Eingang über ein Inversionsglied verbunden ist.

Im folgenden ist die Erfindung anhand eines in der Zeichnung dargestellten Ausführungbeispiels im einzelnen erläutert.

Es zeigen:

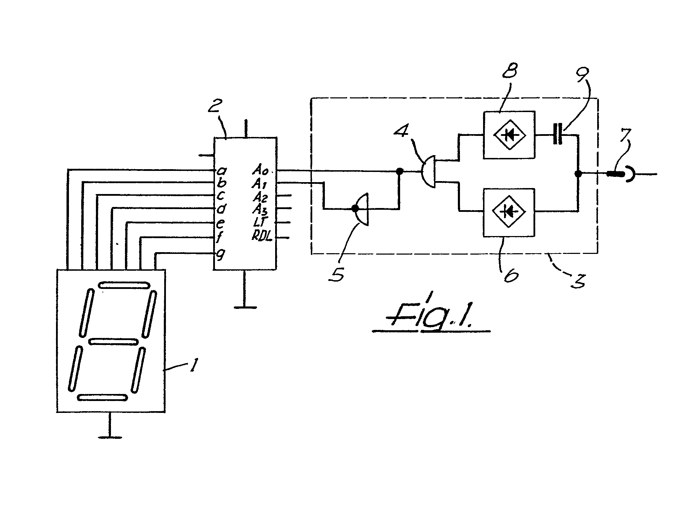

Fig. 1 ein Blockschaltbild des Ausführungsbeispiels,

Fig. 2 eine Ansicht des an einem im Längsschnitt dargestellen Kabelsteckers angesetzten Ausführungsbeispiels.

Eine Vorrichtung zur optischen Anzeige des Betriebszustandes eines isolierten Kabels eines Mittelspannungsnetzes weist ein Display 1 in Form einer einstelligen, numerischen Sieben-Segment-Feldeffekt-Flüssigkristallanzeige auf, die an eine Dekodier- und Treibereinrichtung 2 angeschlossen und mit dieser zu einer Baueinheit vereinigt ist. Sowohl das Display 1 als auch die Dekodier- und Treibereinrichtung 2 haben je einen Masseanschluss. Die Dekodier- und Treibereinrichtung 2 ist an eine als Ganzes mit 3 bezeichnete Eingangsschaltung angeschlossen, die einen direkt mit dem Ausgang eines UND-Gliedes 4 und einen über ein Inversionsglied 5 mit dem Ausgang des UND-Gliedes 4 verbundenen Ausgang hat. Im Ausführungsbeispiel sind diese beiden Ausgänge mit den Eingängen $A_0$ und $A_1$ der Dekodier- und Treibereinrichtung 2 verbunden. Der eine Eingang des UND-Gliedes 4 ist über eine Gleichrichterbrücke 6 mit einem den Eingang der Eingangsschaltung 3 bildenden Steckkontakt 7, der andere Eingang des UND-Gliedes 4 über eine Reihenschaltung aus einer Gleichrichterbrücke 8 und einem Kondensator 9 mit dem Steckkontakt 7 verbunden.

Liegt am Steckkontakt 7 ein Wechselspannungspotential gegenüber Erde an, dann werden beide Eingänge des UND-Gliedes 4 mit einem Signal beaufschlagt, so dass am Ausgang des UND-Gliedes 4 ein logischer H-Pegel vorhanden ist. Da das Inversionsglied 5 das Ausgangssignal des UND-Gliedes invertiert, liegt in diesem Falle am Eingang $A_0$ der Dekodier- und Treibereinrichtung 2 ein H-Pegel, am Eingang $A_1$ ein L-Pegel an. Diese Signalkombination wird derart dekodiert, dass das Display 1 die Zahl 1 anzeigt. Es sind also die Segmente b und c sichtbar.

Liegt der Steckkontakt 7 auf einem Gleichspannungspotential gegenüber Erde, dann liegt der über den Kondensator 9 mit dem Steckkontakt 7 verbundene Eingang des UND-Gliedes 4 auf dem Pegel L und der andere Eingang auf dem Pegel H. Der Ausgang des UND-Gliedes 4 hat daher den Pegel L, so dass in diesem Falle am Eingang $A_0$ der Dekodier- und Treibereinrichtung 2 ein L-Pegel und am Eingang $A_1$ wegen des vorgeschalteten Inversionsgliedes 5 ein H-Pegel vorhanden ist. Diese Signalkombination wird derart dekodiert, dass das Display 1 die Ziffer null anzeigt.

Liegt am Steckkontakt 7 kein Potential oder ein unter der Ansprechgrenze der Dekodier- und Treibereinrichtung 2 liegendes Potential an, dann ist das Display 1 ohne Anzeige.

Eine derartige Vorrichtung kann beispielsweise an Transformatoranschlüssen, schaltbaren T-Muffen, an Kabelsteckern in Schaltanlagen oder an Schaltern zur Anzeige verwendet werden, ob das betreffende Teil und die mit ihm verbundene Leitung eingeschaltet ist, also die Betriebsspannung führt, ob das Gerät oder das Kabel ausgeschaltet, jedoch nicht geerdet ist und deshalb noch eine Ladespannung vorhanden ist, oder ob das Kabel geerdet und gegebenenfalls auch kurzgeschlossen ist, also weder eine Betriebsspannung noch eine Ladespannung vorhanden ist. Im Ausführungbeispiel erscheint im erstgenannten Fall auf dem Display 1 die Ziffer eins. Selbstverständlich könnte auch beispielsweise der Buchstabe E angezeigt werden zur Kennzeichnung des Betriebszustandes «eingeschaltet». Führt das Kabel oder das Gerät nur noch eine positive oder negative Ladespannung, dann erscheint im Ausführungsbeispiel auf dem Display die Ziffer null. Ist das überwachte Gerät oder Kabel geerdet oder ist seine Ladespannung abgeführt, dann erfolgt keine Anzeige auf dem Display 1.

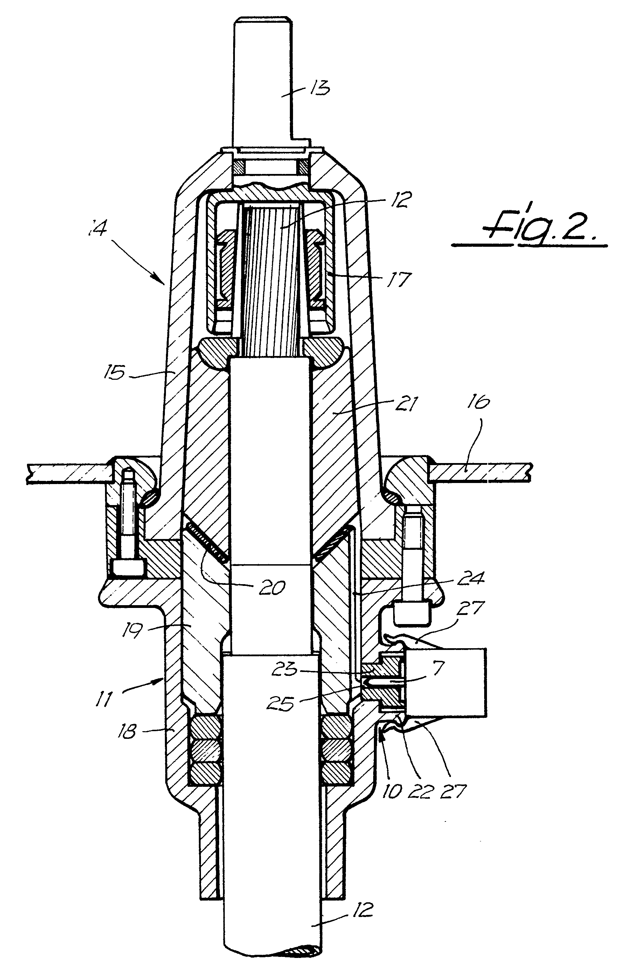

Im Ausführungsbeispiel ist die aus dem Display 1, der Dekodier- und Treibereinrichtung 2 sowie der Eingangsschaltung 3 bestehende Baueinheit so ausgebildet, dass sie an die Anschlusseinrichtung 10 eines Kabelsteckers 11 angesetzt werden kann, mittels dessen ein Mittelspannungskabel 12 mit einem Anschlussbolzen 13 einer Steckbuchse 14 verbindbar ist. Wie Fig. 2 zeigt, weist die Steckbuchse 14 ein isolierendes, becherartiges Gehäuse 15 auf, das eine Trennwand 16 durchgreift und mit dieser fest verbunden ist. Im Inneren des Gehäuses 15 ist eine Kontaktbuchse 17 angeordnet, welche mit dem dicht durch den Boden des Gehäuses 15 hindurchgeführten Anschlussbolzen 13 verbunden ist.

Der Kabelstecker 11 hat ein metallisches, geerdetes Gehäuse 18, durch das das Mittelspannungskabel 12 hindurchgeführt ist. Im Inneren des Gehäuses 18 ist ein Feldabsteuerungskörper 19 angeordnet, welcher an der die Kabelisolation umgebenden, leitenden Schicht anliegt und dessen dem abisolierten Kabelende zugekehrten Stirnfläche als ein Innenkonus ausgebildet ist.

An diesem Innenkonus liegt eine Ankoppelungselektrode 20 an, die in sich geschlossen ist, also einen kegelstumpfartigen Hohlzylinder bildet.

An der dem Feldabsteuerungskörper 19 abgekehrten, konischen Fläche der Ankoppelungselektrode 20 liegt eine elastische, elektrisch isolierende Dichtungshülse 21 mit ihrer einen Stirnfläche an, welche einen korrespondierend ausgebildeten Aussenkonus bildet. Diese Dichtungshülse 21 liegt, wenn der Kabelstecker 11 in der Steckbuchse 14 eingesetzt ist, elektrisch dicht sowohl an der Kabelisolation als auch an der Innenwandung des Gehäuses 15 der Steckbuchse 14 an. Auf das abisolierte Ende des Kabels 12 ist eine mehrfach längsgeschlitzte Buchse aufgesetzt, welche den in die Kontaktbuchse 17 einführbaren Steckkontaktkörper bildet.

Das Gehäuse 18 des Kabelsteckers 11 ist seitlich mit einem Auge 22 versehen, das einen wulstartigen Aussenrand aufweist. In dem Auge 2 ist elektrisch isoliert ein als Prüfungselektrode 23 ausgebildetes Gegenkontaktstück angeordnet, die über eine isolierte Verbindungsleitung 24 galvanisch mit der Ankoppelungselektrode 20 verbunden ist. Die Prüfungselektrode 23 bildet im Ausführungsbeispiel einen Teller mit einem nach aussen hin hochstehenden Rand, um ohne Schwierigkeiten die Prüfspitze eines üblichen Spannungsprüfers ansetzen zu können. Sie ist jedoch weiterhin mit einer zentral angeordneten Bohrung 25 versehen, deren Längsachse lotrecht auf der durch den Teller definierten Ebene steht. Mit einer nicht dargestellten, den ringwulstförmigen Rand des Auges 22 übergreifenden Abdeckkappe kann die Prüfelektrode 23 abgedeckt werden. Der Steckkontakt 7 ist an das Kontaktstück 23 anlegbar, wobei zwei Rastfedern 27 die aus dem Display 1, der Dekodier- und Treibereinrichtung 2 sowie der Eingangsschaltung 3 bestehende Baueinheit mit der Anschlusseinrichtung 10 des Kabelsteckers 11 verrasten.

### Patentansprüche

1. Vorrichtung zur Abgabe eines optischen Signals abhängig von einer elektrischen Betriebsgrösse eines isolierten Kabels eines Energieversorgungsnetzes, mit einer kapazitiv an den Leiter des Kabels angekoppelten Elektrode (20) in einer am Kabelende anzubringenden Garnitur (11) und einer Anzeigevorrichtung (1,2,3), dadurch gekennzeichnet, dass die Anzeigeeinrichtung (1,2,3) ein Mehrsegment-Flüssigkristall-Display (1) sowie eine dieses steuernde Dekodier- und Treibereinrichtung (2) aufweist, welche über eine Eingangsschaltung (3) mit der Elektrode (20) verbindbar ist, und dass das Display (1) sowie die Dekodier- und Treibereinrichtung (2) zu einer Baueinheit vereinigt sind, die an der Garnitur (11) festlegbar und dabei mit der Elektrode (20) verbunden ist.

2. Vorrichtung nach Anspruch 1, dadurch gekennzeichnet, dass die Baueinheit ein an ein Kontaktstück (23) der Garnitur (11) anlegbares Gegenkontaktstück (7) und eine sie in Anlage am Kontaktstück haltende Verbindungseinrichtung (25,27) aufweist.

3. Vorrichtung nach Anspruch 2, dadurch gekennzeichnet, dass die Verbindungseinrichtung als eine Rastvorrichtung (27) oder eine Steckvorrichtung (7,25) ausgebildet ist.

4. Vorrichtung nach Anspruch 3, dadurch gekennzeichnet, dass die Baueinheit in einer Drucktaste angeordnet ist.

5. Vorrichtung nach einem der Ansprüche 1 bis 4, dadurch gekennzeichnet, dass die Eingangsschaltung (3) zwei sich von dem mit der Elektrode (20) verbindbaren Eingang (7) aus teilende Zweige aufweist, die zu den beiden Eingängen eines UND-Gliedes (4) führen und eine Gleichrichterbrücke (6) bzw. einen Kondensator (9) und eine mit diesem in Reihe liegende Gleichrichterbrücke (8) enthalten, und dass der Ausgang des UND-Gliedes (4) mit einem ersten Eingang der Dekodier- und Treibereinrichtung (2) unmittelbar und mit einem zweiten Eingang über ein Inversionsglied (5) verbunden ist.

### Claims

1. Apparatus for producing an optical signal in dependence upon an electric operating magnitude of an insulated cable of an energy supply network, having an electrode (20) capacitively coupled to the conductor of the cable in a fitting (11) to be attached to the end of the cable and an indicator devive (1,2,3), characterized in that the indicator device (1,2,3) comprises a multisegment liquid crystal display (1), a decoding and driver device (2) which controls the display (1) and can be connected to the electrode (20) by an input circuit (3), and in that the display (1) and decoding and driver device (2) are combined to form a unit which can be attached to the fitting (11) and thus connected to the electrode (20).

2. Apparatus according to claim 1, characterized in that the unit comprises a counter-contact element (7) which can be attached to a contact element (23) of the fitting (11), and a connecting device (25,27) keeping the counter-contact element (7) in contact with the contact element.

3. Apparatus according to claim 2, characterised in that the connecting device is in the form of a catch (27) or a plug and socket device (7,25).

4. Apparatus according to claim 3, characterized in that the unit is accommodated in a push button.

5. Apparatus according to one of the claims 1 to 4, characterized in that input circuit (3) comprises two branches separating at the input (7) which can be connected to the electrode (20), which branches lead to the two inputs of AND member (4) and contain a rectifier bridge (6) or a condenser (9) and a rectifier bridge (8) in series therewith respectively, and in that the output of the AND member (4) is directly connected to a first input of the decoding and driver device (2) and is connected to a second input by way of an inversion member (5).

**Revendications**

1. Dispositif servant à délivrer un signal optique en fonction d'une grandeur électrique de service d'un câble isolé d'un réseau d'alimentation en énergie, comportant une électrode (20) accouplée au conducteur du câble, dans un accessoire (11) devant être monté sur l'extrémité de ce dernier, et un dispositif d'affichage (1,2,3), caractérisé en ce que le dispositif d'affichage (1,2,3) comporte un dispositif d'affichage à cristal liquide à plusieurs segments (1) ainsi qu'un dispositif de décodage et d'attaque (2) commandant ce dernier et qui peut être relié par l'intermédiaire d'un circuit d'entrée (3) à l'électrode (20), et que le dispositif d'affichage (1) ainsi que le dispositif de décodage et d'attaque (2) sont réunis pour former un composant unitaire qui peut être fixé sur l'accessoire (11) et est relié à l'électrode (20).

2. Dispositif selon la revendication 1, caractérisé en ce que le composant unitaire comporte un élément de contact antagoniste (7), pouvant être appliqué contre un élément de contact (23) de l'accessoire (11), et un dispositif de jonction (25, 27) maintenant l'accessoire appliqué contre l'élément de contact.

3. Dispositif selon la revendication 2, caractérisé en ce que le dispositif de jonction est réalisé sous la forme d'un dispositif à encliquetage (27) ou d' un dispositif à enfichage (7,25).

4. Dispositif selon la revendication 3, caractérisé en ce que le composant unitaire est disposé dans un bouton-poussoir.

5. Dispositif selon l'une des revendications 1 à 4, caractérisé en ce que le circuit d'entrée (3) comporte deux branches se séparant à partir de l'entrée (7) pouvant être reliées à l'électrode (20) et qui aboutissent aux deux entrés d'un circuit ET (4) et contiennent un pont de redresseurs (6) ou un condensateur (9) et un pont de redresseurs (9) branché en série avec ce dernier, et que le sortie du circuit ET (4) est relié directement à une première entrée du dispositif de décodage et d'attaque (2) et par l'intermédiaire d'un circuit inverseur (5) à une seconde entrée.

_Fig.1._

0012285

Fig.2.

9